# EUROPEAN PATENT APPLICATION

(11) **EP 4 023 689 A1**
(43) Date of publication of application: **06.07.2022**
(21) Application number: 20856317.1
(22) Date of filing: 06.07.2020
(51) Int. Cl.: C08F 290/14, C09J 4/02, C09J 5/00, C09J 11/06, C08F 220/10, C09J 183/04, H01L 21/02, H01L 21/304, H01L 21/60

(54) **METHOD FOR TRANSFERRING MICROSTRUCTURES, AND METHOD FOR MOUNTING MICROSTRUCTURES**

(30) Priority: 27.08.2019 JP 2019154692
(71) Applicant: Shin-Etsu Chemical Co., Ltd., Tokyo 100-0005 (JP)
(72) Inventor: OGAWA, Yoshinori, Tokyo 100-0004 (JP); OHORI, Keiji, Tokyo 100-0004 (JP); UEDA, Shuhei, Joetsu-shi, Niigata 942-8601 (JP); KONDO, Kazunori, Tokyo 100-0004 (JP); OZAI, Toshiyuki, Annaka-shi, Gunma 379-0224 (JP); MATSUMOTO, Nobuaki, Annaka-shi, Gunma 379-0224 (JP); KITAGAWA, Taichi, Annaka-shi, Gunma 379-0224 (JP); OTAKE, Kohei, Annaka-shi, Gunma 379-0224 (JP); KAWAHARA, Minoru, Tokyo 100-0004 (JP)
(74) Representative: Mewburn Ellis LLP
(86) International application number: PCT/JP2020/026368
(87) International publication number: WO 2021/039128

(57) **Abstract**

A method for transferring microstructures, comprising at least the steps of:
(i) bonding a plurality of microstructures formed on one surface of a supplier substrate to a silicone-based rubber layer formed on a donor substrate;
(ii) separating some or all of the plurality of microstructures from the supplier substrate and transferring the some or all of the plurality of microstructures to the donor substrate through the silicone-based rubber layer to produce the donor substrate having the plurality of microstructures temporality fixed thereon;
(iii) washing or neutralizing the donor substrate having the plurality of microstructures temporality fixed thereon;
(iv) drying the washed or neutralized donor substrate having the plurality of microstructures temporality fixed thereon; and
(v) transferring the dried donor substrate having the plurality of microstructures temporality fixed thereof so that the donor substrate can be subjected to a subsequent step. According to the method, a plurality of steps can be carried out while temporality fixing microstructures on a single donor substrate, and therefore it becomes possible to achieve the transfer of the microstructures with high efficiency without increasing the number of steps.

## Description

### TECHNICAL FIELD

The present invention relates to a method for transferring microstructures such as micro-light-emitting diodes (micro-LEDs) and to a method for mounting microstructures.

### BACKGROUND ART

In recent years, electronic devices such as smart phones, liquid-crystal displays and on-board automotive components have been required not only to have a higher performance but also at the same time to save space and energy. The electrical and electronic components built into these devices are being scaled down and miniaturized in response to such societal demands, and so with each passing year the assembly processes for these components have become more complicated and difficult to carry out.

With the increasing complexity of assembly processes for such miniaturized elements, the replacement of adhesive sheets appropriate for the respective steps that has hitherto been carried out with each step results in a poor efficiency of operations and increased production costs. Patent Document 1 addresses these problems by disclosing an adhesive sheet having a high conformance to uneven surface features and excellent heat resistance and chemical resistance that can be used in a plurality of steps in semiconductor wafer processing.

Also, Patent Document 2 describes a method which uses an epoxy-type instant adhesive to adhesively attach a GaN epitaxial wafer grown on a sapphire substrate to a temporary substrate and subsequently releases the GaN layer by laser lift-off, bonds the GaN epitaxial wafer attached to the temporary substrate with a heat-conducting/electricity conducting layer and causes the temporary substrate to fall off by heating at an elevated temperature. By using this method, a device can be obtained in which the GaN epitaxial wafer has been released from the sapphire substrate and transferred to a substrate having excellent heat conductivity and electrical conductivity.

### PRIOR ART DOCUMENTS

### PATENT DOCUMENTS

Patent Document 1: JP-A 2015-59179
Patent Document 2: JP-A 2015-518265

### SUMMARY OF INVENTION

### TECHNICAL PROBLEM

However, the pressure-sensitive adhesive layer of the adhesive sheet in Patent Document 1 contains an ultraviolet-curable pressure-sensitive adhesive. Because ultraviolet irradiation is required for bonding and release, the steps involved are complicated. Also, the adhesive curing conditions and the adhesive (tack) strength depend on the light intensity, and so adjustment of the light intensity is required; depending on how this adjustment is made, problems such as adhesive transfer and decreased yield owing to drop-off may arise.

In Patent Document 2, in the course of bonding at high temperature the GaN epitaxial wafer adhesively attached to the temporary substrate with the heat-conducting/electricity-conducting layer, the epoxy-type instant adhesive carbonizes and falls from the temporary substrate. Hence, the target device and materials cannot be used unless they have a heat resistance up to a temperature at which the epoxy-type instant adhesive can be carbonized. There are also numerous challenges, such as warping of the wafer due to a high-temperature state, adhesive transfer during release and the associated need for cleaning.

The present invention was arrived at in light of the above circumstances. The object of this invention is to provide a method for transferring microstructures and a method for mounting microstructures, which methods, in the transfer of microstructures such as micro-LEDs, enable microstructures temporarily fixed to a single donor substrate to be furnished in this state to a plurality of steps, and therefore do not require a suitable new temporary fixing material for each step and moreover have no need for temporary fixing steps using such temporary fixing materials and for steps to remove the same, thus enabling microstructure transfer to be carried out accurately and efficiently without an increase in the number of steps.

### SOLUTION TO PROBLEM

The inventors have conducted extensive investigations aimed at achieving these objects. As a result, they have discovered a method for transferring microstructures and a method for mounting microstructures, which methods can accurately and efficiently carry out the transfer of microstructures such as micro-LEDs without an increase in the number of steps. This discovery ultimately led to the present invention.

Accordingly, the present invention provides the following method for transferring microstructures and the following method for mounting microstructures.
1. A method for transferring microstructures, which method includes at least the steps of:
   (i) laminating a plurality of microstructures formed on one side of a supply substrate with a silicone rubber layer formed on a donor substrate;
   (ii) separating some or all of the plurality of microstructures from the supply substrate and transferring the separated microstructures to the donor substrate by means of the silicone rubber layer so as to obtain a donor substrate having a plurality of microstructures temporarily fixed thereto;
   (iii) cleaning or neutralizing the donor substrate having a plurality of microstructures temporarily fixed thereto;
   (iv) drying the cleaned or neutralized donor substrate having a plurality of microstructures temporarily fixed thereto; and
   (v) transferring, for use in a subsequent step, the dried donor substrate having a plurality of microstructures temporarily fixed thereto.
2. The microstructure transfer method of 1 above, wherein the donor substrate is a synthetic quartz glass substrate.
3. The microstructure transfer method of 2 above, wherein the synthetic quartz glass substrate has a power spectral density at a spatial frequency of at least 1 mm⁻¹, as measured for a 6.01 mm × 6.01 mm region at a pixel count of 1240×1240 using a white light interferometer, that is 10¹² nm⁴ or less.
4. The microstructure transfer method of any of 1 to 3 above, wherein the lamination step (i) is carried out by applying a load of from 0.01 to 5 kPa.
5. The microstructure transfer method of any of 1 to 4 above, wherein step (ii) is a step which, with the plurality of microstructures formed on one side of the supply substrate in a laminated state with the silicone rubber layer on the donor substrate, irradiates laser light by pulsed oscillation from a side of the supply substrate opposite to the side on which the plurality of microstructures have been formed, releases some or all of the plurality of microstructures from the supply substrate and transfers the released microstructures to the donor substrate, thereby obtaining a donor substrate having a plurality of microstructures temporarily fixed thereto.
6. The microstructure transfer method of 5 above, wherein the laser light by pulsed oscillation is a KrF excimer laser.
7. The microstructure transfer method of 5 or 6 above, wherein the supply substrate is a sapphire substrate.
8. The microstructure transfer method of any of claims 5 to 7 above, wherein the cleaning step (iii) carried out after step (ii) is a step which cleans with an acid.
9. The microstructure transfer method of 8 above, wherein the acid is an acid selected from the group consisting of hydrochloric acid, nitric acid and sulfuric acid.
10. The microstructure transfer method of any of 1 to 4 above, wherein step (ii) is a step which separates some or all of the plurality of microstructures from the supply substrate by etching the supply substrate and transfers the separated microstructures to the silicone rubber layer on the donor substrate, thereby obtaining a donor substrate having a plurality of microstructures temporarily fixed thereto.
11. The microstructure transfer method of 10 above, wherein etching is carried out by wet etching.
12. The microstructure transfer method of 10 or 11 above, wherein the supply substrate is a gallium arsenide substrate.
13. A method for mounting microstructures, which method includes at least the steps of:
   (vi) selectively picking up, from the donor substrate having temporarily fixed thereto the plurality of microstructures transferred by the microstructure transfer method of any of 5 to 9 above, any of the microstructures using a microstructure transfer stamp having a bonding layer made of an ultraviolet-curable silicone pressure-sensitive adhesive composition in cured form on a substrate;
   (vii) transferring the microstructures picked up by the microstructure transfer stamp to desired positions on a circuit board and joining together the microstructures and the circuit board; and
   (viii) mounting the microstructures on the circuit board by separating the picked-up microstructures from the microstructure transfer stamp.
14. The microstructure mounting method of 13 above wherein, in step (vi), the ultraviolet-curable silicone pressure-sensitive adhesive composition in cured form has a higher adhesive strength than the silicone rubber layer on the donor substrate.
15. The microstructure mounting method of 13 or 14 above, wherein the ultraviolet-curable silicone pressure-sensitive adhesive composition in step (vi) is an uncrosslinkable organopolysiloxane resin-free ultraviolet-curable silicone pressure-sensitive adhesive composition that includes:
   (A) 100 parts by weight of an organopolysiloxane having two groups of general formula (1) below per molecule 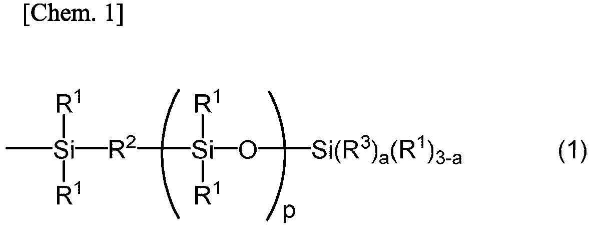 (wherein each R¹ is independently a monovalent hydrocarbon group of 1 to 20 carbon atoms, R² is an oxygen atom or an alkylene group of 1 to 20 carbon atoms, each R³ is independently an acryloyloxyalkyl, methacryloyloxyalkyl, acryloyloxyalkyloxy or methacryloyloxyalkyloxy group; 'p' is a number that satisfies the condition 0 ≤ p ≤ 10; and 'a' is a number that satisfies the condition 1 ≤ a ≤ 3);
   (B) from 1 to 200 parts by weight of a siloxane structure-free monofunctional (meth)acrylate compound;
   (C) from 1 to 1,000 parts by weight of an organopolysiloxane resin which is made of (a) units of general formula (2) below 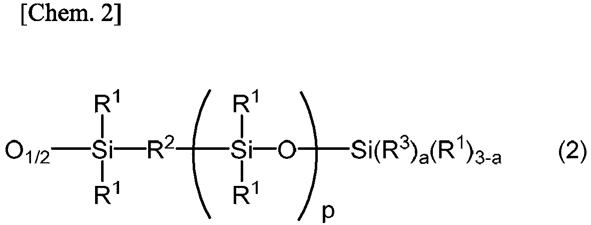 (wherein R¹, R², R³ 'a' and 'p' are as defined above), (b) R⁴₃SiO_{1/2} units (wherein R⁴ is a monovalent hydrocarbon group of 1 to 10 carbon atoms) and (c) SiO_{4/2} units, and in which the molar ratio of the sum of the (a) and (b) units to the (c) units is in the range of 0.4:1 to 1.2:1; and
   (D) from 0.01 to 20 parts by weight of a photopolymerization initiator.
16. The microstructure mounting method of any of 13 to 15 above wherein, in step (vii), the circuit board has a tensile strength which is larger than the adhesive strength of the ultraviolet-curable silicone pressure-sensitive adhesive composition in cured form.

### ADVANTAGEOUS EFFECTS OF INVENTION

The microstructure transfer method of the invention enables microstructures temporarily fixed to a single donor substrate to be furnished in this state to a plurality of steps. Therefore, this method does not require a suitable new temporary fixing material for each step and moreover has no need for temporary fixing steps using such temporary fixing materials and for steps to remove the same, thus making it possible to efficiently transfer microstructures without an increase in the number of steps. Also, because a silicone rubber layer is used in lamination of the microstructures with the donor substrate, instant bonding is possible, and moreover, at the time of release, the microstructures can be released without so-called adhesive transfer, enabling the microstructures to be accurately transferred. This makes it possible to carry out the mounting of microstructures both accurately and efficiently.

### BRIEF DESCRIPTION OF DRAWINGS

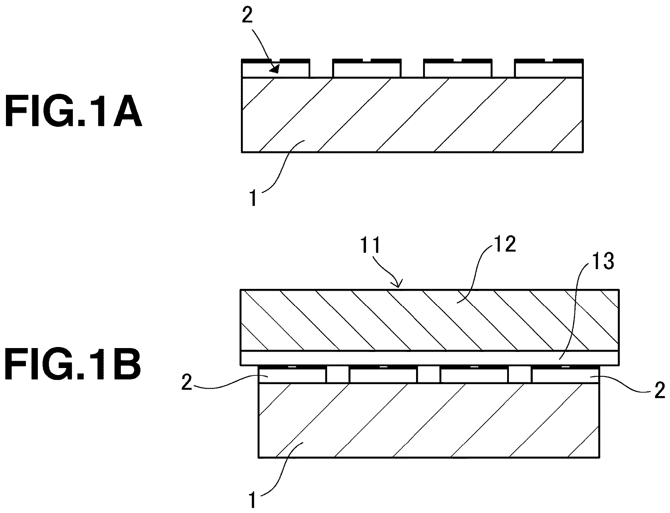

[FIG. 1] FIG. 1A is an explanatory diagram showing, in an embodiment of the inventive method for transferring microstructures, a state in which microstructures have been formed on a supply substrate; and FIG. 1B is an explanatory diagram showing a state in which the microstructures formed on the supply substrate have been laminated with a silicone rubber layer formed on a donor substrate.

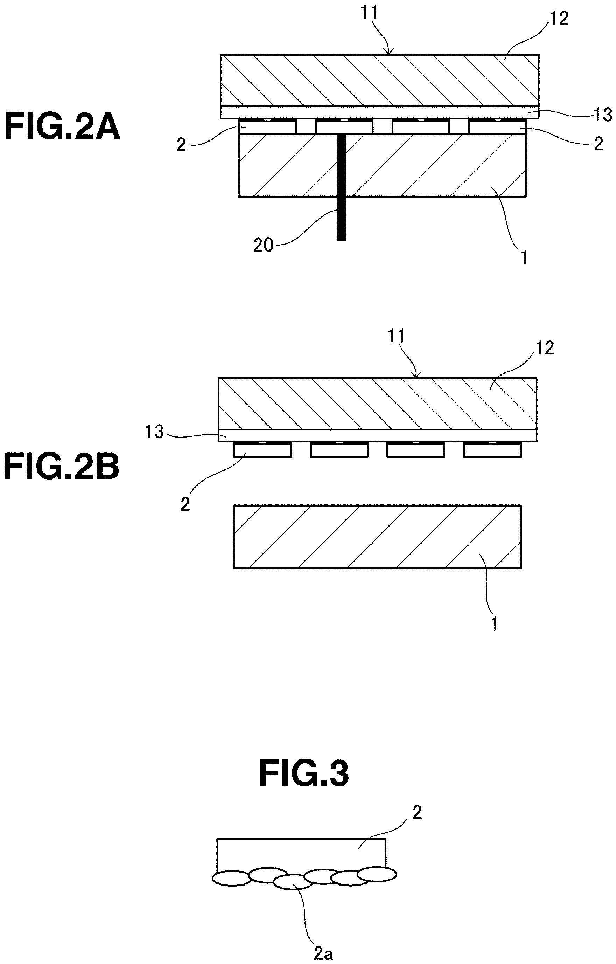

[FIG. 2] FIG. 2A is an explanatory diagram showing, in the same embodiment of the inventive method for transferring microstructures wherein the microstructures formed on the supply substrate have been laminated with the silicone rubber layer formed on the donor substrate, a state in which the microstructures are separated and transferred to the silicone rubber layer on the donor substrate by the irradiation of laser light irradiation from the supply substrate side; and FIG. 2B is an explanatory diagram showing a state in which the microstructures have been separated and transferred to the donor substrate.
[FIG. 3] FIG. 3 is an explanatory diagram showing a state in which, when a gallium nitride microstructure has been irradiated with laser light, metallic gallium that has separated out with melting of the gallium nitride adheres to the microstructures.

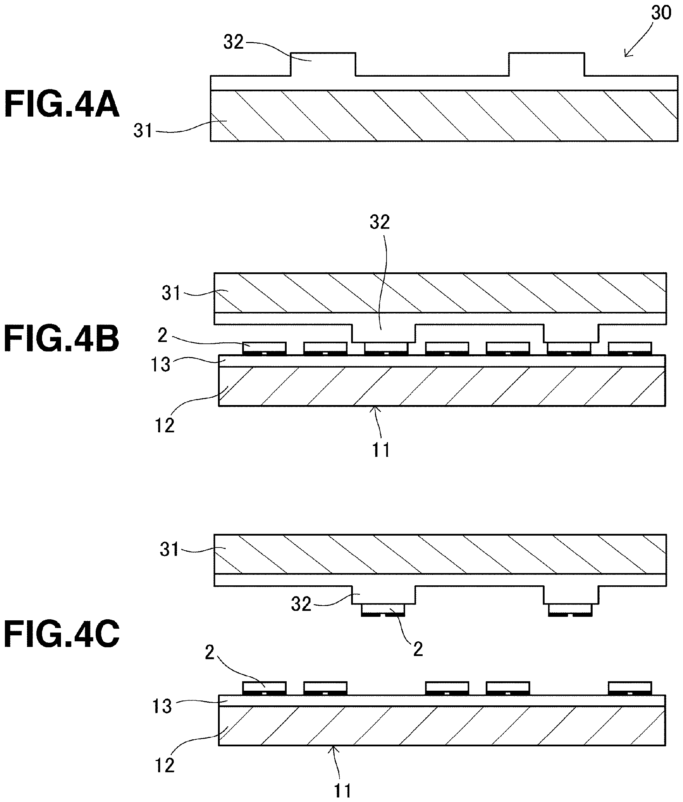

[FIG. 4] FIG. 4A is a schematic diagram showing, in an embodiment of the inventive method for mounting microstructures, a stamp for transferring microstructures; FIG. 4B is an explanatory diagram showing a state in which microstructures temporarily fixed to a donor substrate have been laminated with the microstructure transfer stamp; and FIG. 4C is an explanatory diagram showing a state in which microstructures have been picked up by the microstructure transfer stamp.

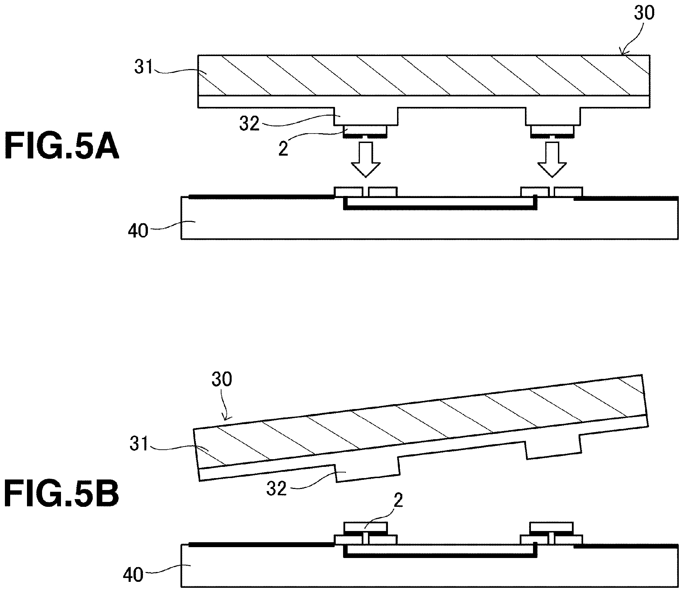

[FIG. 5] FIG. 5A is an explanatory diagram showing, in the same embodiment of the inventive method for mounting microstructures, a state in which microstructures are picked up and supplied to a circuit board; and FIG. 5B is an explanatory diagram showing a state in which the microstructure transfer stamp following pick-up has been moved away from the circuit board.

### DESCRIPTION OF EMBODIMENTS

The inventive method for transferring microstructures is described below step-by-step while referring to the diagrams.

### (i) The step of laminating a plurality of microstructures formed on one side of a supply substrate with a donor substrate having a silicone rubber layer on a substrate

A plurality of microstructures 2 are formed on one side of a supply substrate 1 (FIG. 1A).

Examples of substrates that may be used here as the supply substrate include sapphire substrates, GaAs substrates (gallium arsenide substrates), Si substrates and SiC substrates. The substrate may be of any diameter.

Exemplary microstructures include light-emitting diodes (also referred to below as LEDs) such as micro-LEDs, discrete semiconductors such as power semiconductors, logic ICs and memory ICs.

The microstructures may be, for example, devices obtained by providing the basic structure of the device via conventional semiconductor front-end processes such as epitaxial growth on a supply substrate, ion implantation, wet etching, dry etching, vapor deposition and electrode formation, and subsequently separating the devices by a conventional technique such as blade dicing, dry etching or laser dicing to a depth that separates the devices.

For example, in cases where the microstructures are LEDs, a buffer layer is provided on a 4-inch sapphire substrate and a 3-µm N-type GaN layer is formed thereon, following which a known light-emitting layer structure is provided, giving a P-type GaN layer-bearing LED epi substrate having a total epi thickness of 4 µm. The N layer is then locally exposed by dry etching, following which known processes are used to form P-type electrodes on the P layer and to form N-type electrodes in shapes that contact the exposed N layer. Next, LED devices of predetermined sizes are separated by carrying out laser dicing in such a way as to reach at least the sapphire substrate, placing the devices in a completely separated state.

The microstructures may be of any size. For example, in the case of power LEDs, the size is on the order of 1 mm square. In other cases, the size is on the order of 300 µm square for LED devices, on the order of 100 µm square for mini-LEDs, on the order of 60 µm square or less for micro-LEDs, and 30 µm or less for micro-LEDs that are ultra-small in size.

The microstructures mentioned above are generally square in shape, although the shape of the microstructures is not limited to this in the present invention. For example, in the case of micro-LEDs, rectangular shapes that measure from 30 to 60 µm on one side and from 10 to 30 µm on the other side are acceptable.

The thickness of the microstructures varies with the thickness of epitaxial growth on the supply substrate and is not particularly limited, although a thickness of from about 3 µm to about 10 µm is preferred.

As shown in FIG. 1B, the donor substrate 11 has a silicone rubber layer 13 provided on a substrate 12.

Examples of substrates that may be used in the donor substrate include synthetic quartz glass substrates and float glass substrates. Fron the standpoint of flatness in particular, a synthetic quartz glass substrate is preferred.

The substrate used in the donor substrate is preferably of the same size as or larger than the diameter of the supply substrate. Specifically, in cases where the supply substrate is a sapphire substrate having a diameter of 4 inches, a donor substrate having a diameter of 4 to 8 inches may be used.

In order for some or all of a plurality of microstructures to be reliably transferred from the supply substrate to the donor substrate, it is preferable, in lamination of the plurality of microstructures formed on one side of the supply substrate with the donor substrate having a silicone rubber layer provided on a substrate, for the individual microstructures to be briefly and uniformly in a temporarily fixed state to the silicone rubber layer of the donor substrate.

In order to temporarily fix the microstructures accurately in this way, it is preferable for the substrate used in the donor substrate to have a power spectral density at a spatial frequency of at least 1 mm⁻¹, as measured for a 6.01 mm × 6.01 mm region at a pixel count of 1240×1240 using a white light interferometer, that is 10¹² nm⁴ or less. Particularly in cases where the microstructures are micro-LEDs, taking into account the distance between the microstructures, it is preferable for the substrate used to have a power spectral density at a spatial frequency of at least 1 mm⁻¹, as measured for a 6.01 mm × 6.01 mm region at a pixel count of 1240×1240 using a white light interferometer, of 10⁹ nm⁴ or less.

To temporarily fix the microstructures accurately, the substrate used in the donor substrate is preferably one having a small thickness variation. For example, the total thickness variation (TTV) as measured with a wavelength conversion Fizeau flatness tester from Mizojiri Optical Co., Ltd. is preferably 2 µm or less, more preferably 1 µm or less, and even more preferably 0.5 µm or less.

The silicone rubber that forms the silicone rubber layer is preferably one which is capable of instantly bonding and for which release without so-called adhesive transfer is possible. Examples include the SIM series from Shin-Etsu Chemical Co., Ltd. From the standpoint of the curing time in particular, suitable examples include silicone rubber compositions such as SIM-360 and the STP series.

The silicone rubber layer is formed by, for example, spin coating the above silicone rubber composition to a thickness of preferably from 1 to 200 µm, more preferably from 5 to 100 µm, and even more preferably from 10 to 50 µm, and then placing it in a heating oven at preferably between 20°C and 200°C for 5 to 90 minutes to effect curing.

LEDs in particular are made of a single-crystal material and, being small and thin, are prone to cracking and chipping. Hence, when bonded using a curable adhesive or the like, cracking and chipping may occur due to stress from the material. By contrast, in the case of a rubber layer as in this invention, lamination is effected by surface tack of the rubber layer, and so the material is not subjected to stress, resulting in an improved yield.

Lamination of the plurality of microstructures formed on one surface of the supply substrate with the silicone rubber layer on the donor substrate is not particularly limited, so long as a plurality of microstructures can be transferred to the silicone rubber layer. For example, it is preferable to carry out lamination while applying a load of preferably from 0.05 to 1.0 MPa, and more preferably from 0.10 to 0.5 MPa.

### (ii) The step of separating some or all of the plurality of microstructures from the supply substrate and transferring the separated microstructures to the donor substrate by means of the silicone rubber layer so as to obtain a donor substrate having a plurality of microstructures temporarily fixed thereto

Broadly speaking, there are two techniques for separating some or all of the plurality of microstructures from the supply substrate and transferring them to the donor substrate by means of the silicone rubber layer so as to obtain a donor substrate having a plurality of microstructures temporarily fixed thereto. These two techniques are laser lift-off and etching.

When laser lift-off is used, as shown in FIG. 2A, with the plurality of microstructures 2 formed on one side of the supply substrate 1 and the silicone rubber layer 13 of the donor substrate 11 in a laminated state, laser light 20 by pulsed oscillation is irradiated from the side of the supply substrate 1 opposite to that on which the plurality of microstructures 2 have been formed, thereby obtaining a donor substrate on which the plurality of microstructures 2 from the supply substrate 1 have been temporarily fixed to the silicone rubber layer 13 (FIG. 2B).

For example, in the case of gallium nitride microstructures that are bonded to a supply substrate such as a sapphire substrate, due to the irradiation of laser light such as an excimer laser or a YAG laser, gallium nitride in the irradiated region melts, releasing the gallium nitride microstructures from the supply substrate. In this case, particularly in micro-LEDs, from the standpoint of microstructure reliability, KrF excimer laser light is preferred.

Specifically, laser light is selectively irradiated, causing laser ablation to arise at the interface between the selected microstructures and the supply substrate. As a result, in the case of gallium nitride microstructures, for example, between the selected microstructures and the supply substrate, gallium nitride decomposes to metallic gallium and nitrogen and gas evolution occurs, enabling the microstructures to be released with relative ease.

When the etching technique is used, some or all of the plurality of microstructures are released from the supply substrate and transferred to the donor substrate by etching the supply substrate, giving a donor substrate having a plurality of microstructures temporarily fixed thereto. For example, in the case of microstructures that are bonded to a supply substrate by gallium arsenide, the microstructures are released from the supply substrate by wet etching the supply substrate using a mixture of ammonia and hydrogen peroxide.

### (iii) The step of cleaning or neutralizing the donor substrate having a plurality of microstructures temporarily fixed thereto

The step of cleaning or neutralizing the donor substrate to which a plurality of microstructures have been temporarily fixed differs depending on the method used to release some or all of the plurality of microstructures from the supply substrate.

Specifically, when the laser lift-off technique is used, cleaning is carried out with an acid. For example, in the case of gallium nitride microstructures, metallic gallium 2a adhering to the back of the microstructures is cleaned off (FIG. 3).

The acid used in cleaning here is not particularly limited, so long as metal adhering to the back of the microstructures can be cleaned off. However, a strong acid selected from the group consisting of hydrochloric acid, nitric acid and sulfuric acid is preferred.

When the etching technique is used, such as when a GaAs substrate is etched with a mixture of ammonia and hydrogen peroxide (APM), cleaning is carried out with pure water.

Also, it is preferable, depending on the type of etchant used, to provide a neutralizing step before the cleaning step. For example, when an alkaline etchant is used, it is desirable to insert a neutralizing step with an acidic solution; when an acidic etchant is used, it is desirable to insert a neutralizing step with an alkaline solution. Specifically, in cases where hydrofluoric acid and nitric acid are used as the etchant for a Si substrate, neutralization with ammonia water is preferred. Following completion of the neutralizing step, it is preferable to carry out cleaning with pure water.

Aside from the above methods, it is also possible to remove the supply substrate by a mechanical method. For example, use can be made of a method in which the microstructures are mechanically released by inserting a cutting blade between the supply substrate and the microstructures, or a method which cuts away the supply substrate by grinding from the supply substrate side.

In the present invention, regardless of the method of separation used, because the microstructures are temporarily fixed to the donor substrate and do not separate off during the cleaning or neutralizing step, the trouble of replacing the substrate with, for example, another substrate can be eliminated. Moreover, the falling off of microstructures associated with such replacement does not occur, and so the height variation can be held down to preferably 10 µm or less, more preferably 5 µm or less, and even more preferably 2 µm or less.

### (iv) The step of drying the cleaned donor substrate having a plurality of microstructures temporarily fixed thereto

After the cleaning step, the donor substrate having a plurality of microstructures temporarily fixed thereto is dried in the usual manner with the microstructures remaining temporarily fixed; that is, without replacement with another substrate or the like. Drying is carried out in dry air at between 60°C and 100°C for a period of from 10 to 60 minutes.

### (v) The step of transferring, for use in a subsequent step, the dried donor substrate having a plurality of microstructures temporarily fixed thereto

The dried donor substrate having a plurality of microstructures temporarily fixed thereto is transferred, with the microstructures remaining temporarily fixed, for use in a subsequent step.

Next, the inventive method for mounting microstructures is described in detail step by step.

### (vi) The step of selectively picking up, from the donor substrate having temporarily fixed thereto the plurality of microstructures transferred by the above transfer method, any of the microstructures using a microstructure transfer stamp having a bonding layer made of an ultraviolet-curable silicone pressure-sensitive adhesive composition in cured form on a stamp substrate

As shown in FIG. 4A, a microstructure transfer stamp 30 has, on a stamp substrate 31, an ultraviolet-curable silicone pressure-sensitive adhesive composition in cured form that serves as a bonding layer 32.

Examples of stamp substrates that may be used in the microstructure transfer stamp include plastic film, float glass, synthetic quartz glass, and metals such as aluminum, copper and stainless steel. The thickness, type and the like are also not particularly limited, and the substrate may even be one that has been chemically strengthened.

In cases where a plurality of microstructures separated by given intervals are used as micro-LEDs that are picked up at the same time, the shape of the substrate surface is important and so a synthetic quartz glass substrate is preferred. In such a case, the power spectral density and thickness variation of the synthetic quartz glass substrate are preferably the same as for the synthetic quartz glass substrate used as the donor substrate.

To enhance adhesion between the stamp substrate and the ultraviolet-curable silicone pressure-sensitive adhesive composition in cured form, use can be made of a stamp substrate that has been subjected beforehand to primer treatment, plasma treatment or the like. To suppress displacement and increase pick-up accuracy at the time of microstructure pickup, it is preferable to use a synthetic quartz glass substrate having a high degree of flatness.

The ultraviolet-curable silicone adhesive composition that is used may be an uncrosslinkable organopolysiloxane resin-free ultraviolet-curable silicone pressure-sensitive adhesive composition which includes (A) 100 parts by weight of an organopolysiloxane having two groups of general formula (1) below per molecule; (B) from 1 to 200 parts by weight of a siloxane structure-free monofunctional (meth)acrylate compound; (C) from 1 to 1,000 parts by weight of an organopolysiloxane resin made up of (a) units of general formula (2) below, (b) R⁴₃SiO_{1/2} units (wherein R⁴ is a monovalent hydrocarbon group of 1 to 10 carbon atoms) and (c) SiO_{4/2} units, and in which the molar ratio of the sum of the (a) and (b) units to the (c) units is in the range of 0.4:1 to 1.2:1; and (D) from 0.01 to 20 parts by weight of a photopolymerization initiator.

The components of this ultraviolet-curable silicone pressure-sensitive adhesive composition are described in detail below.

### (A) Organopolysiloxane

Component (A), which is a crosslinking ingredient in this composition, is an organopolysiloxane having two groups of general formula (1) below per molecule and having a main chain that is substantially composed of repeating diorganosiloxane units.

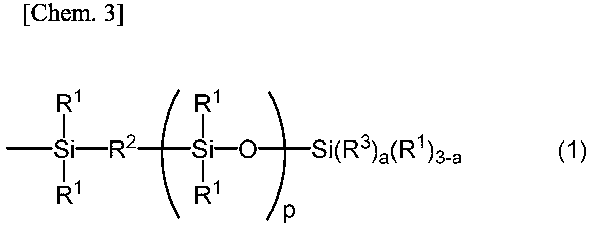

In formula (1), each R¹ is independently a monovalent hydrocarbon group of 1 to 20 carbon atoms, and is preferably a monovalent hydrocarbon group of 1 to 10 carbon atoms, and more preferably 1 to 8 carbon atoms, exclusive of aliphatic unsaturated groups; R² is an oxygen atom or an alkylene group of 1 to 20, preferably 1 to 10, and more preferably 1 to 5, carbon atoms; each R³ is independently an acryloyloxyalkyl, methacryloyloxyalkyl, acryloyloxyalkyloxy or methacryloyloxyalkyloxy group; 'p' is a number that satisfies the condition 0 ≤ p ≤ 10; and 'a' is a number that satisfies the condition 1 ≤ a ≤ 3.

In formula (1), the monovalent hydrocarbon groups of 1 to 20 carbon atoms serving as R¹ may be linear, branched or cyclic. Specific examples include alkyl groups such as methyl, ethyl, n-propyl, isopropyl, n-butyl, isobutyl, tert-butyl, n-hexyl, cyclohexyl, n-octyl, 2-ethylhexyl and n-decyl groups; alkenyl groups such as vinyl, allyl (2-propenyl), 1-propenyl, isopropenyl and butenyl groups; aryl groups such as phenyl, tolyl, xylyl and naphthyl groups; and aralkyl groups such as benzyl, phenylethyl and phenylpropyl groups.

Some or all of the hydrogen atoms bonded to the carbon atoms on these monovalent hydrocarbon groups may be substituted with other substituents. Specific examples of such substituted hydrocarbon groups include halogen-substituted hydrocarbon groups such as chloromethyl, bromoethyl and trifluoropropyl; and cyano-substituted hydrocarbon groups such as the cyanoethyl group.

Of these, R¹ is preferably an alkyl group of 1 to 5 carbon atoms or a phenyl group, and is more preferably a methyl, ethyl or phenyl group.

The alkylene group of 1 to 20 carbon atoms serving as R² may be linear, branched or cyclic. Specific examples include methylene, ethylene, propylene, trimethylene, tetramethylene, isobutylene, pentamethylene, hexamethylene, cyclohexylene, heptamethylene, octamethylene, nonamethylene and decylene groups.

Of these, R² is preferably an oxygen atom or a methylene, ethylene or trimethylene group, and is more preferably an oxygen atom or an ethylene group.

The number of carbon atoms on the alkyl (alkylene) group in the acryloyloxyalkyl, methacryloyloxyalkyl, acryloyloxyalkyloxy or methacryloyloxyalkyloxy group serving as R³, although not particularly limited, is preferably from 1 to 10, and more preferably from 1 to 5. These alkyl groups are exemplified by, of the groups mentioned above for R¹, those having from 1 to 10 carbon atoms.

Specific examples of R³ include, but are not limited to, those of the following formulas. 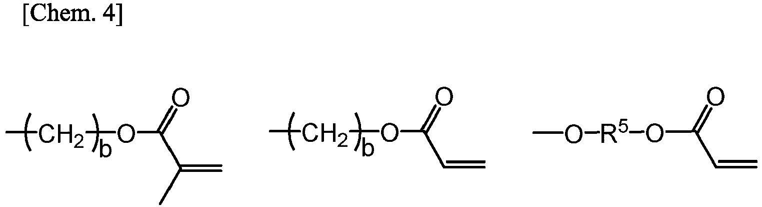 (wherein b is a number that satisfies the condition 1 ≤ b ≤ 4, and R⁵ is an alkylene group of 1 to 10 carbon atoms.)

The letter 'p' above represents a number that satisfies the condition 0 ≤ p ≤ 10, with 0 or 1 being preferred. The letter 'a' represents a number that satisfies the condition 1 ≤ a ≤ 3, with 1 or 2 being preferred.

The bonding positions of the groups of general formula (1) above in the organopolysiloxane molecule of component (A) may be at the ends of the molecular chain or at non-terminal positions on the molecular chain (i.e., partway along the molecular chain or side chains on the molecular chain), or both. However, from the standpoint of flexibility, it is desirable for these groups to be present only at the ends of the molecular chain.

In the organopolysiloxane molecule of component (A), the silicon-bonded organic groups other than the groups of general formula (1) are exemplified by the same groups as mentioned above for R¹. Monovalent hydrocarbon groups of 1 to 12 carbon atoms, preferably 1 to 10 carbon atoms, exclusive of aliphatic unsaturated groups, are especially preferred.

These are exemplified by the same groups as mentioned above for R¹. From the standpoint of the ease of synthesis, alkyl groups, aryl groups and halogenated alkyl groups are preferred; methyl, phenyl and trifluoropropyl groups are more preferred.

The molecular structure of component (A) is basically a linear or branched structure (including linear structures with some branching on the main chain) in which the main chain is made up of repeating diorganosiloxane units. A linear diorganopolysiloxane in which both ends of the molecular chain are capped with groups of general formula (1) above is especially preferred.

Component (A) may be a single polymer having these molecular structures, a copolymer made up of these molecular structures, or a mixture of two or more such polymers.

The organopolysiloxane of component (A) has a viscosity at 25°C which, to further enhance the ease of working with the composition and the mechanical properties of the cured composition, is preferably from 10 to 100,000 mPa·s, and more preferably from 10 to 50,000 mPa·s. This viscosity range, in the case of linear organopolysiloxanes, generally corresponds to a number-average degree of polymerization of from about 10 to about 2,000, and preferably from about 50 to about 1,100. In this invention, the viscosity can be measured with a rotational viscometer (examples of which include BL-type, BH-type, BS-type and cone/plate viscometers, and also rheometers).

In the invention, the degree of polymerization (or molecular weight) can be determined as the polystyrene-equivalent number-average degree of polymerization (or number-average molecular weight) in gel permeation chromatography (GPC) using, for example, toluene or the like as the developing solvent.

Specific examples of the organopolysiloxane of component (A) include, but are not limited to, those of formulas (3) to (5) below. 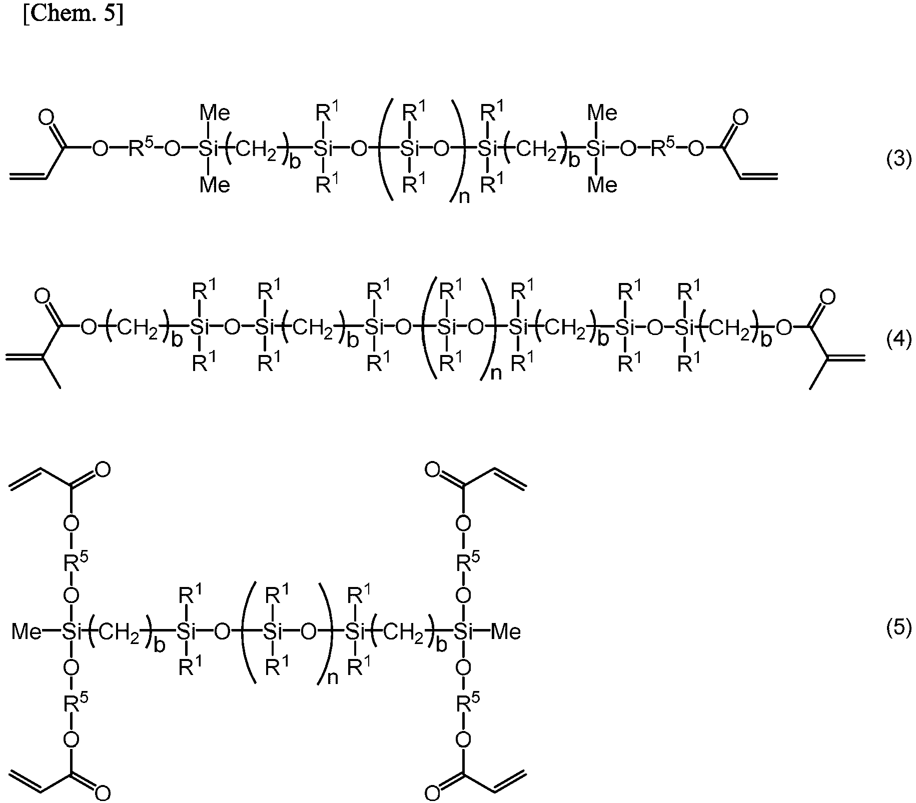 (wherein R¹, R⁵ and b are as defined above, Me stands for a methyl group, and n is a number which sets the viscosity of the organopolysiloxane to the above-indicated value, preferably from 1 to 800, and more preferably from 50 to 600.)

Such an organopolysiloxane may be prepared by a known method. For example, the polysiloxane of formula (3) above can be obtained by reacting 2-hydroxyethyl acrylate with the product of a hydrosilylation reaction between a dimethylsiloxane/diphenylsiloxane copolymer capped at both ends with dimethylvinylsiloxy groups and chlorodimethylsilane.

The organopolysiloxane of formula (4) can be obtained as the product of a hydrosilylation reaction between a dimethylsiloxane/diphenylsiloxane copolymer capped at both ends with dimethylvinylsiloxy groups and 3-(1,1,3,3-tetramethyldisiloxanyl)propyl methacrylate (CAS No. 96474-12-3).

The organopolysiloxane of formula (5) can be obtained by reacting 2-hydroxyethyl acrylate with the product of a hydrosilylation reaction between a dimethylsiloxane/diphenylsiloxane copolymer capped at both ends with dimethylvinylsiloxy groups and dichloromethylsilane.

### (B) Siloxane Structure-Free Monofunctional (Meth)Acrylate Compound

Specific examples of the siloxane structure-free monofunctional (meth)acrylate compound (B) include isoamyl acrylate, lauryl acrylate, stearyl acrylate, ethoxy diethylene glycol acrylate, methoxy triethylene glycol acrylate, 2-ethylhexyl diglycol acrylate, phenoxyethyl acrylate, phenoxydiethylene glycol acrylate, tetrahydrofurfuryl acrylate and isobornyl acrylate. These may be used singly or two or more may be used in admixture.

Of these, isobornyl acrylate is especially preferred.

The monofunctional (meth)acrylate compound of component (B) is added in an amount, per 100 parts by weight of component (A), in the range of 1 to 200 parts by weight. At a component (B) amount of addition below 1 part by weight per 100 parts by weight of component (A), the curability of the composition and the strength and tack of the cured product are inadequate. On the other hand, although the viscosity of the overall composition can be adjusted by increasing the amount of component (B) added, at an amount of addition greater than 200 parts by weight per 100 parts by weight of component (A), the desired tack cannot be obtained.

It is especially preferable for component (B) to be added in an amount of from 5 to 100 parts by weight per 100 parts by weight of component (A).

### (C) Organopolysiloxane Resin

Component (C), which is one of the crosslinking ingredients of the composition, is an organopolysiloxane resin that has (meth)acryloyloxy-containing groups and is made up of (a) units of general formula (2) below (M^{A} units), (b) R⁴₃SiO_{1/2} units (M units) and (c) SiO_{4/2} units (Q units). R⁴ represents a monovalent hydrocarbon group of 1 to 10 carbon atoms. 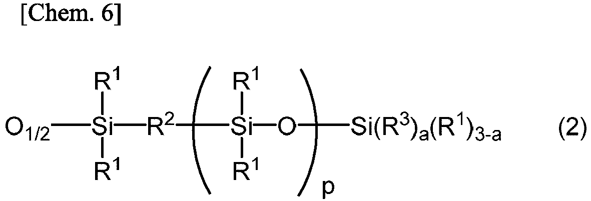 (wherein R¹, R², R³, a and p are as defined above.)

The monovalent hydrocarbon group of 1 to 10 carbon atoms serving as R⁴ is exemplified by, of the groups mentioned above for R¹, groups in which the number of carbon atoms is from 1 to 10. Of these, alkyl groups of 1 to 5 carbon atoms, such as methyl, ethyl, n-propyl and n-butyl groups, and aryl groups of 6 to 10 carbon atoms, such as phenyl and tolyl groups, are preferred. Methyl, ethyl and phenyl groups are more preferred.

The monovalent hydrocarbon group of R⁴ above may be, as with R¹, groups in which some or all of the hydrogen atoms bonded to carbon atoms are substituted with the other substituents mentioned above.

In component (C), the molar ratio among (a) units of general formula (2) (M^{A} units), (b) R⁴₃SiO_{1/2} units (M units) and (c) SiO_{4/2} units (Q units), expressed as M^{A} units + M units : Q units, is from 0.4:1 to 1.2:1. When the molar ratio of M^{A} units + M units is less than 0.4, the viscosity of the composition may become very high; when it exceeds 1.2, the mechanical properties of the cured form thereof may decline.

In order to set the viscosity of the composition and the mechanical properties of the cured form thereof within more suitable ranges, the molar ratio of the M^{A} and M units to the Q units (M^{A} units + M units : Q units) is preferably from 0.6:1 to 1.2:1.

The rubber properties of the cured composition can be adjusted by means of the molar ratio between the M^{A} units and the M units. From the standpoint of the strength of the cured composition, the ratio expressed as M^{A} units : M units is preferably from 0.01:1 to 1:1, and more preferably from 0.05:1 to 0.5:1.

The organopolysiloxane resin of component (C) is added in an amount, per 100 parts by weight of component (A), within a range of 1 to 1,000 parts by weight, preferably from 5 to 500 parts by weight, and more preferably from 10 to 200 parts by weight. At less than 1 part by weight, the rubber strength of the cured composition decreases; at more than 1,000 parts by weight, the adhesive (tack) strength decreases.

### (D) Photopolymerization Initiator

Specific examples of photopolymerization initiators that may be used include 2,2-diethoxyacetophenone, 2,2-dimethoxy-1,2-diphenylethan-1-one (Irgacure 651, from BASF), 1-hydroxycyclohexyl phenyl ketone (Irgacure 184, from BASF), 2-hydroxy-2-methyl-1-phenylpropan-1-one (Irgacure 1173, from BASF), 2-hydroxy-1 - {4-[4-(2-hydroxy-2-methylpropionyl)benzyl]phenyl} -2-methylpropan-1 -one (Irgacure 127, from BASF), phenylglyoxylic acid methyl ester (Irgacure MBF, from BASF), 2-methyl-1-[4-(methylthio)phenyl]-2-morpholinopropan-1-one (Irgacure 907, from BASF), 2-benzyl-2-dimethylamino-1-(4-morpholinophenyl)-1-butanone (Irgacure 369, from BASF), phenylbis(2,4,6-trimethylbenzoyl)phosphine oxide (Irgacure 819, from BASF) and diphenyl(2,4,6-trimethylbenzoyl)phosphine oxide (Irgacure TPO, from BASF). These may be used singly or two or more may be used in combination.

Of these, from the standpoint of the compatibility with component (A), 2,2-diethoxyacetophenone, 2-hydroxy-2-methyl-1-phenylpropan-1-one (Irgacure 1173, from BASF), phenylbis(2,4,6-trimethylbenzoyl)phosphine oxide (Irgacure 819, from BASF) and diphenyl(2,4,6-trimethylbenzoyl)phosphine oxide (Irgacure TPO, from BASF) are preferred.

The photopolymerization initiator is added in an amount, per 100 parts by weight of component (A), in the range of 0.01 to 20 parts by weight. At less than 0.01 part by weight, the curability is inadequate; at more than 20 parts by weight, the deep curability worsens.

### (E) Finely Powdered Silica

The finely powdered silica used as component (E) is an optional ingredient that serves primarily to adjust the viscosity of the composition, and is exemplified by fumed silica (dry silica) and precipitated silica (wet silica). Fused silica (dry silica) is preferred. Including component (E) further increases the hardness of the cured composition and also has the effect of suppressing displacement when transferring microstructures and other components.

The specific surface area of component (E), although not particularly limited, is preferably from 50 to 400 m²/g, and more preferably from 100 to 350 m²/g. At a specific surface area below 50 m²/g, the thixotropic properties of the composition may be inadequate; at more than 400 m²/g, the viscosity of the composition may rise excessively and the workability may worsen. The specific surface area is a measured value obtained by the BET method.

The finely divided silica serving as component (E) may be of one type used alone, or two or more types may be used in combination.

These finely divided silicas may be used directly without modification, or may be used after treatment with a surface hydrophobizing treatment agent.

In this case, a finely divided silica treated beforehand with a surface treatment agent may be used, or the surface treatment agent may be added during kneading of the finely divided silica and kneading and surface treatment may be carried out at the same time.

Examples of these surface treatment agents include alkylalkoxysilanes, alkylchlorosilanes, alkylsilazanes and silane coupling agents. These may be of one type used alone, or two or more may be used at the same time or under different timing.

In the ultraviolet-curable silicone pressure-sensitive adhesive composition, when component (E) is used, the amount of addition per 100 parts by weight of component (A) is preferably in the range of 1 to 200 parts by weight, more preferably 5 to 150 parts by weight, and even more preferably 10 to 100 parts by weight.

### (F) Antistatic Agent

The antistatic agent (F) is an optional ingredient which has the role of lowering the surface resistivity and imparting antistatic properties to a material. Exemplary antistatic agents include alkali metal or alkaline earth metal salts, and ionic liquids. As used herein, "ionic liquids" refer to molten salts that are liquid at room temperature (25°C); these are also called room-temperature molten salts. The ionic liquids refer in particular to molten salts having melting points of 50°C or below, preferably from -100°C to 30°C, and more preferably from -50°C to 20°C. Such ionic liquids have desirable properties, including the absence of a vapor pressure (non-volatility), a high heat resistance, non-combustibility and chemical stability.

Exemplary alkali metal or alkaline earth metal salts include salts of alkali metals such as lithium, sodium and potassium, and salts of alkaline earth metals such as calcium and barium. Specific examples include alkali metals salts such as LiClO₄, LiCF₃SO₃, LiN(CF₃SO₂)₂, LiAsF₆, LiCl, NaSCN, KSCN, NaCl, NaI and KI; and alkaline earth metal salts such as Ca(ClO₄)₂ and Ba(ClO₄)₂.

Of these, because of their low resistance values and solubility, lithium salts such as LiClO₄, LiCF₃SO₃, LiN(CF₃SO₂)₂, LaAsF₆ and LiCl are preferred. LiCF₃SO3 and LiN(CF₃SO₂)₂ are especially preferred.

The ionic liquid consists of a quaternary ammonium cation and an anion. The quaternary ammonium cation is in the form of imidazolium, pyridinium, or a cation of the formula R⁶₄N⁺ (wherein each R⁶ is independently a hydrogen atom or an organic group of 1 to 20 carbon atoms).

Organic groups represented by R⁶ above are exemplified by monovalent hydrocarbon groups of 1 to 20 carbon atoms and alkoxyalkyl groups. Specific examples include alkyl groups such as methyl, pentyl, hexyl and heptyl groups; aryl groups such as phenyl, tolyl, xylyl and naphthyl groups; aralkyl groups such as benzyl and phenethyl groups; cycloalkyl groups such as cyclopentyl, cyclohexyl and cyclooctyl groups; and alkoxyalkyl groups such as the ethoxyethyl group (-CH₂CH₂OCH₂CH₃). Two of the organic groups represented by R⁶ may bond to form a cyclic structure, in which case the two R⁶ groups together form a divalent organic group. The main chain of this divalent organic group may be composed of carbon alone, or may include therein a heteroatom such as an oxygen atom or a nitrogen atom. Examples include divalent hydrocarbon groups (e.g., alkylene groups of 3 to 10 carbon atoms) of the formula -(CH₂)_{c}-O-(CH₂)_{d}- (wherein c is an integer from 1 to 5, d is an integer from 1 to 5, and c+d is an integer from 4 to 10).

Specific examples of cations represented by R⁶₄N⁺ above include the methyltri-n-octylammonium cation, the ethoxyethylmethylpyrrolidinium cation and the ethoxyethylmethylmorpholinium cation.

The anion is not particularly limited, although preferred examples include AlCl₄⁻, Al₃Cl₁₀⁻, Al₂Cl₇⁻, ClO₄⁻, PF₆⁻, BF₄⁻, CF₃SO₃⁻, (CF₃SO₂)₂N⁻ and (CF₃SO₂)₃C⁻. PF₆⁻, CF₄⁻, CF₃SO₃⁻ and (CF₃SO₂)₂N⁻ are more preferred.

The above antistatic agent may be of one type used alone, or two or more may be used in combination.

From the standpoint of the antistatic properties and heat resistance, the amount of component (F) included per 100 parts by weight of component (A) is preferably from 0.001 to 10 parts by weight, and more preferably from 0.005 to 10 parts by weight.

The cured product obtained from the ultraviolet-curable silicone pressure-sensitive adhesive composition has an antistatic performance such that, when the surface of the cured product is charged with 6 kV of static electricity by corona discharge using the Static Honestmeter (Shishido Electrostatic Ltd.), the time until the static voltage falls to one-half the initial value (half-life) is preferably 2 minutes or less, and more preferably 1 minute or less.

Also, as mentioned above, the ultraviolet-curable silicone pressure-sensitive adhesive composition does not include any uncrosslinkable organopolysiloxane resin. If an uncrosslinkable organopolysiloxane resin is included, sticky material ends up adhering to the microstructures, which is undesirable.

Such organopolysiloxane resins are exemplified by organopolysiloxane resins consisting of (d) R⁴₃SiO_{1/2} units (R⁴ being as defined above) and (e) SiO_{4/2} units in a molar ratio of (d) units to (e) units within the range of 0.4:1 to 1.2:1, and are commonly used as ingredients that impart tackiness to the cured product.

Additives such as colorants (pigments or dyes), silane coupling agents, tackifiers, polymerization inhibitors, antioxidants, ultraviolet absorbers that are light-resistant stabilizers, and light stabilizers may be included in the ultraviolet-curable silicone pressure-sensitive adhesive composition within ranges that do not detract from the advantageous effects of the invention.

In addition, another resin composition may be suitably mixed and used together with the ultraviolet-curable silicone pressure-sensitive adhesive composition.

The ultraviolet-curable silicone pressure-sensitive adhesive composition can be obtained by mixing together in any order above components (A) to (D) and, optionally, component (E), component (F) and other ingredients, and stirring, etc. The apparatus used for operations such as stirring is not particularly limited. For example, an automated mortar, three-roll mill, ball mill, planetary mixer or the like may be used. These apparatuses may also be suitably combined.

From the standpoint of formability and workability during coating, the ultraviolet-curable silicone pressure-sensitive adhesive composition has a viscosity, as measured at 23°C using a rotational viscometer, which is preferably 5,000 Pa·s or less, more preferably 3,000 Pa·s or less, and even more preferably 1,500 Pa·s or less. At more than 5,000 Pa·s, the workability may markedly worsen.

The ultraviolet-curable silicone pressure-sensitive adhesive composition rapidly cures under ultraviolet irradiation.

Exemplary sources of the ultraviolet light that is irradiated include UV LED lamps, high-pressure mercury-vapor lamps, ultrahigh-pressure mercury-vapor lamps, metal halide lamps, carbon arc lamps and xenon lamps.

The amount of ultraviolet irradiation (cumulative exposure dose) with respect to, for example, a sheet of the inventive composition formed to a thickness of about 2.0 mm, is preferably from 1 to 10,000 mJ/cm², and more preferably from 10 to 8,000 mJ/cm². That is, when ultraviolet light at an illuminance of 100 mW/cm² is used, the ultraviolet light may be irradiated for a period of from about 0.01 second to about 100 seconds.

In this invention, the adhesive strength of the cured product obtained by ultraviolet irradiation is not particularly limited. However, taking into consideration the balance between releasability and retention of the objects to be transferred, the adhesive strength is preferably from 0.001 to 100 MPa, and more preferably form 0.01 to 50 MPa.

To keep cohesive failure from occurring during molding or during the transfer of microcomponents such as micro-LEDs and other devices, the cured product obtained from the ultraviolet-curable silicone pressure-sensitive adhesive composition has a tensile strength (JIS K 6249: 2003) at a thickness of 2.0 mm that is preferably at least 1 MPa, and more preferably at least 2 MPa.

In above step (vi) of the inventive mounting method, techniques for selectively picking up any of the microstructures from the donor substrate to which a plurality of microstructures transferred by the above microstructure transfer method are temporarily fixed include vacuum pick-up and also, for example, a technique which, as shown in FIG. 4B, laminates a plurality of microstructures 2 that have been temporarily fixed to the donor substrate 11 with a microstructure transfer stamp 30 having a bonding layer 32 made of the cured form of the ultraviolet-curable silicone pressure-sensitive adhesive composition on a stamp substrate 31 and then, as shown in FIG. 4C, separates some or all of the plurality of microstructures 2 from the donor substrate 11 and picks them up with the bonding layer 32.

Lamination is not particularly limited, so long as a plurality of microstructures can be transferred to the bonding layer. For example, it is desirable to carry out lamination by applying a load of preferably from 0.1 to 3.0 MPa, and more preferably from 0.2 to 2.0 MPa.

At the time of pickup, it is preferable for the cured form of the ultraviolet-curable silicone pressure-sensitive adhesive composition to have an adhesive strength that is higher than the adhesive strength of the silicone rubber layer of the donor substrate. Specifically, it is desirable for the adhesive strength of the cured form of the ultraviolet-curable silicone pressure-sensitive adhesive composition to be preferably from 0.1 to 2.0 MPa higher, more preferably from 0.2 to 1.5 MPa higher, and even more preferably from 0.2 to 1.0 MPa higher, than the adhesive strength of the silicone rubber layer of the donor substrate. This has the effect, when any microstructures are selectively picked up in this way from the donor substrate to which a plurality of microstructures have been temporarily fixed, of eliminating the need for another step to separate the plurality of microstructures from the donor substrate, thereby making instant bonding possible.

### (vii) The step of transferring the microstructures picked up by the microstructure transfer stamp to desired positions on a circuit board and joining together the microstructures and the circuit board

The microstructures picked up by the microstructure transfer stamp are transferred to desired positions on a circuit board.

As shown in FIG. 5A, the transferred microstructures 2 are supplied and bonded to desired positions on a circuit board 40 where the microstructures 2 should be bonded, and are thereby joined together with the circuit board. The joining method may involve the use of, for example, an electrically conductive adhesive or soldering.

During transfer, it is preferable for the tensile strength of the circuit board to be stronger than the adhesive strength of the cured form of the ultraviolet-curable silicone pressure-sensitive adhesive composition. Specifically, it is desirable for the circuit board to have a tensile strength which is preferably at least 0.1 MPa higher, and more preferably at least 0.2 MPa higher, than the adhesive strength of the cured form of the ultraviolet-curable silicone pressure-sensitive adhesive composition.

As a result, when selectively transferring any of the microstructures from the bonding layer made of the cured form of the ultraviolet-curable silicone pressure-sensitive adhesive composition to which a plurality of microstructures have been temporarily fixed, this eliminates the need for another step in order to separate the plurality of microstructures from the bonding layer, making instant bonding possible.

Here, the circuit board is not particularly limited, so long as it is one which has, formed at the surface or at the surface and the interior of an insulating substrate and based on a given circuit design, a pattern made of an electrically conductive material for connecting between circuit components. Also, the circuit board may be a highly rigid substrate or may be a flexible substrate that is capable of bending; and it includes also a backplane.

If necessary, the microstructures that have been picked up may, prior to transfer to a circuit board as described above, be transferred to another intermediate substrate and then transferred to the circuit board.

### (viii) The step of mounting the microstructures on the circuit board by separating the picked-up microstructures from the microstructure transfer stamp

After the microstructures and the circuit board have been joined together, as shown in FIG. 5B, the stamp 30 is moved away from the circuit board 40.

### EXAMPLES

Examples are given below to more concretely illustrate the invention, although the invention is not limited by these Examples. In the formulas below, "Me" stands for a methyl group, "Ph" stands for a phenyl group and "Vi" stands for a vinyl group.

Blue micro-LEDs having a wavelength of 450 nm were formed on a 4-inch diameter, 530-µm thick sapphire substrate as the supply substrate.

The LED epi structure was obtained by using metal organic chemical vapor deposition (MOCVD) to form on the sapphire substrate in the following order: a low-temperature GaN buffer layer, an n-type contact GaN layer, an n-clad AlInGaN layer, an active layer (an InGaN multi-quantum well layer adjusted to a wavelength of 450 nm), a p-type AlInGaN clad layer, and a p-type contact layer.

Following completion of the above epitaxial growth, activation annealing of the LED was carried out, a mask of predetermined shape was formed on the surface of the p-type contact layer that is the topmost layer, and etching was carried out until the surface of the n-type contact layer was exposed. After etching, n electrodes made of Ti/Al were formed on the surface of the n-type contact layer and p electrodes made of Ni/Au were formed on the surface of the p-type contact layer. Following electrode formation, device separation of the wafer into 30 µm × 15 µm rectangular chips was carried out by laser, giving a sapphire substrate having a plurality of micro-LEDs formed on one side (supply substrate).

Next, a 6-inch diameter, 1-mm thick synthetic quartz glass wafer was furnished as the donor substrate. The synthetic quartz glass wafer had a total thickness variation (TTV) of 0.8 µm and a power spectral density at a spatial frequency of at least 1 mm⁻¹, as measured for a 6.01 mm × 6.01 mm region at a pixel count of 1240×1240 using a white light interferometer, that was 10¹¹ nm⁴.

SIM-360 (Shin-Etsu Chemical Co., Ltd.) was coated to a thickness of 20 µm on this synthetic quartz glass wafer and the workpiece was placed in a heating oven at 150°C for 30 minutes and cured, thereby forming a silicone rubber layer on the synthetic quartz glass wafer.

The sapphire substrate was placed on the donor substrate so as to bring the plurality of micro-LEDs formed on the sapphire substrate into contact with the silicone rubber layer, and a load of 0.12 MPa was uniformly applied.

The united sapphire substrate and donor substrate were set in a laser release system and a KrF excimer laser (wavelength, 248 nm) was irradiated from the side opposite to that on which the micro-LEDs were formed. The substrate susceptor was driven in such a way as to enable the laser light to scan the entire surface of the substrate.

When the sapphire substrate and the donor substrate were taken out of the laser release system and the sapphire substrate was slid to the side, it was possible to remove the micro-LEDs from the sapphire substrate while they remained attached to the donor substrate. At the completion of this step, all of the micro-LEDs were transferred from the sapphire substrate to the donor substrate without even a single micro-LED falling from the donor substrate.

Next, in order to remove metallic Ga adhering to the micro-LEDs, the donor substrate to which the micro-LEDs were temporarily fixed was set in a cleaning cassette and was cleaned by up-and-down movement at a rate of 20 strokes per minute for 5 minutes in ultrahigh-purity grade concentrated hydrochloric acid (10 wt%). At the completion of this step as well, not even a single micro-LED had fallen from the donor substrate. Using the front side of the donor substrate as the reference plane, the in-plane height variation on the back sides of the micro-LEDs from which metallic Ga had been removed was 2 µm or less.

Next, the cassette containing the donor substrate was transferred to a pure water tank and residual hydrochloric acid solution was washed off by 10 minutes of rinsing with pure water. At the completion of this step as well, not a single micro-LED had fallen off. Using the front side of the donor substrate as the reference plane, the in-plane height variation on the back sides of the micro-LEDs from which metallic Ga had been removed was 2 µm or less.

Next, the cassette containing the donor substrate was set in a dryer that circulates dry air and 30 minutes of drying was carried out with 60°C dry air. At the completion of this step as well, not a single micro-LED had fallen off. Using the front side of the donor substrate as the reference plane, the in-plane height variation on the back sides of the micro-LEDs from which metallic Ga had been removed was 2 µm or less.

The dried donor substrate was set in a visual inspection system with the micro-LEDs facing up, and chips with cracking, chipping, defective electrode structures and the like were removed at this stage. Not a single micro-LED was out of place on the donor substrate. Using the front side of the donor substrate as the reference plane, the in-plane height variation on the back sides of the micro-LEDs from which metallic Ga had been removed was 2 µm or less.

In the next step, using a microstructure transfer stamp having raised and recessed features formed at given internals, random micro-LEDs were selected from the donor substrate and these were picked up and mounted on a circuit board.

A microstructure transfer stamp consisting of a substrate having thereon a bonding layer made of the cured form of an ultraviolet-curable silicone pressure-sensitive adhesive composition was obtained by molding the composition on the stamp substrate.

A synthetic quartz glass substrate having a thickness of 1.2 mm and a size of 35 mm × 35 mm was furnished as the stamp substrate. The synthetic quartz glass wafer had a total thickness variation (TTV) of 0.3 µm and a power spectral density at a spatial frequency of at least 1 mm⁻¹, as measured for a 6.01 mm × 6.01 mm region at a pixel count of 1240×1240 using a white light interferometer, of 10¹¹ nm⁴.

The ultraviolet-curable silicone pressure-sensitive adhesive composition was prepared by mixing together (A) 100 parts by weight of the organopolysiloxane indicated below as A-1 and (C) 160 parts by weight of a xylene solution containing the organopolysiloxane resin indicated below as C-1, driving off the xylene under reduced pressure at 100°C, then adding in and mixing together (B) 20 parts by weight of isobornyl acrylate (Light Acrylate IB-XA, from Kyoeisha Chemical Co., Ltd.) and (D) 2 parts by weight of 2-hydroxy-2-methyl-1-phenylpropan-1-one (Irgacure 1173, from BASF).

### <A-1>

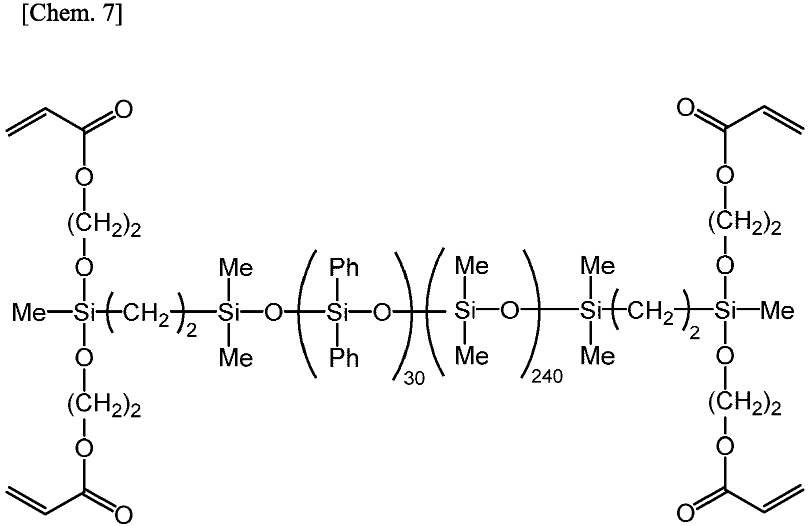

### <C-1>

A 50 wt% xylene solution of an organopolysiloxane resin (number-average molecular weight, 5,700) consisting of methacryloyloxy group-containing units of formula (6) below, ViMe₂SiO_{1/2} units, Me₃SiO_{1/2} units and SiO₂ units, in which the molar ratio expressed as methacryloyloxy group-containing units/(ViMe₂SiO_{1/2} units)/(Me₃SiO_{1/2} units)/(SiO₂) units is 0.07/0.10/0.67/1.00.

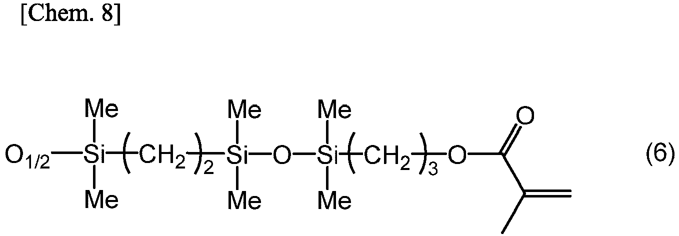

Next, the gap between the synthetic quartz glass substrate and the mold was filled with the ultraviolet-curable silicone pressure-sensitive adhesive composition, which was then cured in a nitrogen atmosphere at room temperature (25°C) by irradiation with 365 nm wavelength ultraviolet light to an exposure dose of 4,000 mJ/cm² using the Eye UV Electronic Controller (model UBX0601-01) from Eye Graphics Co., Ltd. The mold was then removed, giving a micro-LED transfer stamp.

Raised areas of the stamp were pressed against the back sides of the micro-LEDs under a load of 0.50 MPa, whereupon micro-LEDs at the places that had been pressed against separated from the donor substrate and were picked up by the micro-LED transfer stamp.

The raised areas where micro-LEDs were picked up were then pressed against a circuit board having formed thereon, at the same pitch as the raised and recessed areas of the micro-LED transfer stamp, electrodes for electrically connecting with electrodes on the micro-LED, thereby mounting the micro-LEDs onto the circuit board.

### REFERENCE SIGNS LIST

- 1: Supply substrate
- 2: Microstructure
- 2a: Metallic gallium
- 11: Donor substrate
- 12: Substrate
- 13: Silicone rubber layer
- 20: Laser light
- 30: Microstructure transfer stamp
- 31: Stamp substrate
- 32: Bonding layer
- 40: Circuit board

## Claims

1. A method for transferring microstructures, comprising at least the steps of:
(i) laminating a plurality of microstructures formed on one side of a supply substrate with a silicone rubber layer formed on a donor substrate;
(ii) separating some or all of the plurality of microstructures from the supply substrate and transferring the separated microstructures to the donor substrate by means of the silicone rubber layer so as to obtain a donor substrate having a plurality of microstructures temporarily fixed thereto;
(iii) cleaning or neutralizing the donor substrate having a plurality of microstructures temporarily fixed thereto;
(iv) drying the cleaned or neutralized donor substrate having a plurality of microstructures temporarily fixed thereto; and
(v) transferring, for use in a subsequent step, the dried donor substrate having a plurality of microstructures temporarily fixed thereto.

2. The microstructure transfer method of claim 1, wherein the donor substrate is a synthetic quartz glass substrate.

3. The microstructure transfer method of claim 2, wherein the synthetic quartz glass substrate has a power spectral density at a spatial frequency of at least 1 mm⁻¹, as measured for a 6.01 mm × 6.01 mm region at a pixel count of 1240×1240 using a white light interferometer, that is 10¹² nm⁴ or less.

4. The microstructure transfer method of any one of claims 1 to 3, wherein the lamination step (i) is carried out by applying a load of from 0.01 to 5 kPa.

5. The microstructure transfer method of any one of claims 1 to 4, wherein step (ii) is a step which, with the plurality of microstructures formed on one side of the supply substrate in a laminated state with the silicone rubber layer on the donor substrate, irradiates laser light by pulsed oscillation from a side of the supply substrate opposite to the side on which the plurality of microstructures have been formed, releases some or all of the plurality of microstructures from the supply substrate and transfers the released microstructures to the donor substrate, thereby obtaining a donor substrate having a plurality of microstructures temporarily fixed thereto.

6. The microstructure transfer method of claim 5, wherein the laser light by pulsed oscillation is a KrF excimer laser.

7. The microstructure transfer method of claim 5 or 6, wherein the supply substrate is a sapphire substrate.

8. The microstructure transfer method of any one of claims 5 to 7, wherein the cleaning step (iii) carried out after step (ii) is a step which cleans with an acid.

9. The microstructure transfer method of claim 8, wherein the acid is an acid selected from the group consisting of hydrochloric acid, nitric acid and sulfuric acid.

10. The microstructure transfer method of any one of claims 1 to 4, wherein step (ii) is a step which separates some or all of the plurality of microstructures from the supply substrate by etching the supply substrate and transfers the separated microstructures to the silicone rubber layer on the donor substrate, thereby obtaining a donor substrate having a plurality of microstructures temporarily fixed thereto.

11. The microstructure transfer method of claim 10, wherein etching is carried out by wet etching.

12. The microstructure transfer method of claim 10 or 11, wherein the supply substrate is a gallium arsenide substrate.

13. A method for mounting microstructures, comprising at least the steps of:
(vi) selectively picking up, from the donor substrate having temporarily fixed thereto the plurality of microstructures transferred by the microstructure transfer method of any one of claims 5 to 9, any of the microstructures using a microstructure transfer stamp having a bonding layer made of an ultraviolet-curable silicone pressure-sensitive adhesive composition in cured form on a substrate;
(vii) transferring the microstructures picked up by the microstructure transfer stamp to desired positions on a circuit board and joining together the microstructures and the circuit board; and
(viii) mounting the microstructures on the circuit board by separating the picked-up microstructures from the microstructure transfer stamp.

14. The microstructure mounting method of claim 13 wherein, in step (vi), the ultraviolet-curable silicone pressure-sensitive adhesive composition in cured form has a higher adhesive strength than the silicone rubber layer on the donor substrate.

15. The microstructure mounting method of claim 13 or 14, wherein the ultraviolet-curable silicone pressure-sensitive adhesive composition in step (vi) is an uncrosslinkable organopolysiloxane resin-free ultraviolet-curable silicone pressure-sensitive adhesive composition comprising:
(A) 100 parts by weight of an organopolysiloxane having two groups of general formula (1) below per molecule 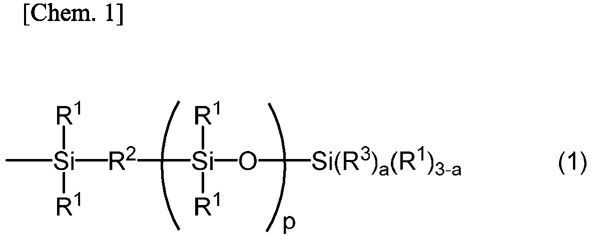 (wherein each R¹ is independently a monovalent hydrocarbon group of 1 to 20 carbon atoms, R² is an oxygen atom or an alkylene group of 1 to 20 carbon atoms, each R³ is independently an acryloyloxyalkyl, methacryloyloxyalkyl, acryloyloxyalkyloxy or methacryloyloxyalkyloxy group; 'p' is a number that satisfies the condition 0 ≤ p ≤ 10; and 'a' is a number that satisfies the condition 1 ≤ a ≤ 3);
(B) from 1 to 200 parts by weight of a siloxane structure-free monofunctional (meth)acrylate compound;
(C) from 1 to 1,000 parts by weight of an organopolysiloxane resin which is comprised of (a) units of general formula (2) below 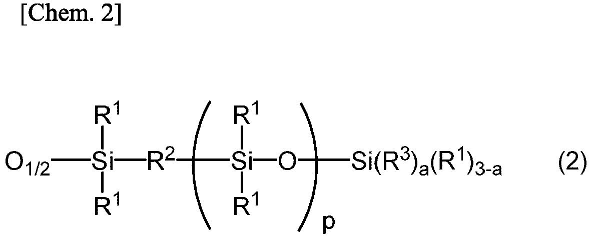 (wherein R¹, R², R³ 'a' and 'p' are as defined above), (b) R⁴₃SiO_{1/2} units (wherein R⁴ is a monovalent hydrocarbon group of 1 to 10 carbon atoms) and (c) SiO_{4/2} units, and in which the molar ratio of the sum of the (a) and (b) units to the (c) units is in the range of 0.4:1 to 1.2:1; and
(D) from 0.01 to 20 parts by weight of a photopolymerization initiator.

16. The microstructure mounting method of any one of claims 13 to 15 wherein, in step (vii), the circuit board has a tensile strength which is larger than the adhesive strength of the ultraviolet-curable silicone pressure-sensitive adhesive composition in cured form.
